# EUROPEAN PATENT APPLICATION

(11) **EP 2 572 877 A2**
(43) Date of publication of application: **27.03.2013**
(21) Application number: 12003009.3
(22) Date of filing: 28.04.2012
(51) Int. Cl.: B32B 17/10, H01L 31/042, H01L 31/048

(54) **Photovoltaic modules comprising a backsheet and electrical insulating layer(s) which are highly permeable to corrosive degradation by-products**

(30) Priority: 20.09.2011 EP 11007640; 04.11.2011 EP 11008801; 12.03.2012 EP 12001690
(71) Applicant: RENOLIT Belgium N.V., 9700 Oudenaarde (BE)
(72) Inventor: Rummens, Francois, 1082 Bruxelles (BE)
(74) Representative: Wagner, Jutta

(57) **Abstract**

The invention addresses the problem of generation and trapping of (acetic) acid within crystalline PV modules where such modules comprise encapsulant material at least partly on base of EVA or on at least partly on base of other acid generating material. To solve the object of the invention, one provides:
- An insulating film (7) to electrically separate (insulate) conductive ribbons (6) from other conductive parts of the PV modules, like PV cells (4), such a film having a high permeability to acids, avoiding them to be locally trapped,
- Encapsulants (2 and 5) with reduced generation of acids,
- Backsheets (11 -10) having a high permeability to acids.

The present text describes also innovative backsheets comprising FPP layers and/or adapted Polyamide layers allowing achieving a relative thermal endurance or a RTI of 105°C or more.

A innnovative encapsulant is also described having excellent additives retention, transparency and allowing for reduced potential induced degradation of PV modules.

## Description

The present invention relates to photovoltaic (PV) modules comprising:
- a transparent front layer,
- PV cells,
- adhesive layer(s) (also called encapsulants films or potants) releasing detrimental (by-)products,
- interconnecting ribbon,
- electrically insulating layers and
- a backsheet, especially a detrimental (by-)products permeable backsheet, e.g.:
   o a mainly TPO based backsheet possibly including the rear encapsulant layer
   o a Polyamide based backsheet.
   o a partly micro-perforated backsheet.

Innovative durable cost effective backsheets, possibly easing the automation of production of PV modules, are also described. Such backsheets are preferably coextruded multi-layers based and comprise:
- a cost effective electrical insulating layer or layers on base of UV and Heat stabilized Flexible PolyPropylene (FPP).
- a polyamide layer or layers to improve the heat resistance, i.e. achieving mechanical integrity (e.g. reduced risk of perforation of the backsheet by soldering defects or loops between metallic ribbons) during lamination of the backsheet.
By adapted formulation (anti-oxidants and/or fillers content and/or polymeric modification) of the layers, the backsheet achieves a long term thermal stability temperature (Relative Thermal Index or RTI ; UL 746 B; Relative Thermal Endurance or RTE according IEC 61215 (2005-04) part 10.13 or IEC 61646 (2008-05) part 10.13) of 105°C or more and excellent Partial Discharge behavior.

Innovative encapsulants are also described allowing achieving high transparency and limiting the phenomena of PID (Potential Induced Degradation) of Crystaline Silicone PV cells.

### BACKGROUND OF THE INVENTION

As during production and aging of PV modules, detrimental (by-) products e.g. corrosive by-products, especially acids, like acetic acid from EVA encapsulants or like acrylic or maleic acids from tie-layers, etc. are often released by encapsulants, it is advantageous to use a backsheet which is permeable to such products, allowing them to escape easily from the PV modules reducing their detrimental effect. Classical backsheets comprising a PET film are a relatively good barrier against migration of by-products such as acetic acid and limit egress of such by-products from the PV module.

PV cells are generally interconnected by so called interconnecting conducting ribbons (mainly tin plated copper ribbon). Such conducting ribbons will in many cases extend and cross under the backside of PV cells and need therefore to be electrically separated from the backside of the PV cells (electrodes) by an insulating layer.

A piece of classical backsheet like Tedlar/PET/Tedlar (TPT) or more generally a piece of a film comprising a PET film (like a multi-layer film of the type PE / PET / PE) between EVA encapsulants could be used for this purpose but this will lead to locally high concentration of detrimental (by-)products, in this case acetic acid. Local severe corrosion may then be observed in hot and humid conditions, especially when backsheets with high permeability to such by-products (e.g. acetic acids), are used. The diffusion of the by-products from under those PET comprising films is much slower than the diffusion out of the module.

In such a case areas of locally higher concentration of the by-products are created inside the PV modules versus region of lower concentration, creating concentration cells, well known to accelerate corrosion locally:
i. The region between the cells backside and the PET comprising separation layer, e.g. TPT insulating layer, traps acetic acid by-products of EVA degradation and the corrosion attack, e.g. of conductive ribbon, is significantly increased in that area.
ii. The other regions let acetic acid escape, through the backsheet, from the PV module and corrosion is kept limited.

Within the scope of this invention, a photovoltaic module (also abbreviated PV module) comprises at least the following layers/components:
- a transparent front layer,
- adhesive layer(s) containing or releasing detrimental
   (by-)products, especially corrosive (by-)products, more specifically acidic (by-)products like e.g. acetic, acrylic acid or maleic acid, during module production and/or in use (after aging and hydrolysis of polymeric encapsulants),
- an active layer comprising a photovoltaic material sandwiched between a front and a back electrode layer
- (interconnecting) conducting ribbon
- electrically insulating film (separation layer) between (interconnecting) conducting ribbon and PV material electrodes with good permeability to detrimental (by-) products e.g. by micro-perforation or by a composition which is highly permeable to such (by-) products
- a backsheet, especially a backsheet allowing high egress of detrimental by-products, like acetic acid or other acids, e.g:
   o a mainly FPP based backsheet possibly with integrated adhesive as described in patent applications PCT/EP 2010/004335 ("Photovoltaic modules with Polypropylene based backsheet"), EP N°: 10007553.0 ("Photovoltaic Modules using an adhesive integrated Heat Resistant multi-layer Backsheet") and PCT/EP2009/000665 ("Photovoltaic modules and Production Process")
   o a Polyamide (Nylon) based backsheet
   o a classical backsheet like Tedlar/PET/Tedlar (TPT) or a film comprising a PET film (like a multi-layer film of the type PE / PET / PET), which is, at least partly, micro-perforated, through its thickness, to increase permeability
   o a backsheet obtained on base of a combination of above mentioned layers.

Described Backsheets (see especially PCT/EP 2010/004335 ("Photovoltaic modules with Polypropylene based backsheet")) comprising a polyamide layer or layers and a Flexible Polypropylene layer or layers, can't, as such, achieve a RTI or RTE of 105 °C or more. They need to be modified. Innovative modification of such backsheet is disclosed to meet such very difficult requirement.

Polyamide is a poor dielectric. When polyamide is combined with polyolefins (PolyPropylene, PolyEthylene), it is possible to produce backsheet with excellent Partial Discharge behavior. This behavior defines the thickness of the backsheet. Combined means coextruded or blended.

Usually, backsheets are multi-layers sheets and are produced in several steps. First, films are produced by extrusion and then such films are laminated with the help of adhesives to produce the backsheet. An example is the so called TPT backsheets, which are in fact a assembly of two Tedlar ® films glued on both sides of a central PET film. The PET film brings the dielectric properties and the Tedlar films bring weathering protection.

It is more cost effective to produce the back sheet by coextrusion (one step process), where the main layer(s) are based on cost effective dielectric raw material like Flexible PolyPropylene. To assure mechanical integrity of the backsheet during lamination (avoid perforation e.g. by soldering defects or loops in interconnecting metallic ribbon), it is preferred to include heat resistant layers like Polyamide layer or layers in the backsheet. Possible polyamides are polyamide 6, 11 or 12. Polyamide 6 is extremely cost effective for the purpose of heat resistance (avoiding risk of perforation, etc.) but is a poor dielectric and can only be used as part of a backsheet when protected against humidity by the FPP layers.

Such backsheets are described in patent application PCT/EP 2010/004335 ("Photovoltaic modules with Polypropylene based backsheet"), in European patent application N°: 10007553.0 ("Photovoltaic Modules using an adhesive integrated Heat Resistant multi-layer Backsheet") and in PCT/EP2009/000665 ("Photovoltaic modules and Production Process")

It is further advantageous to modify the Polyamide by blending it with polyolefins to improve its dielectric performances.

It is anyway required that backsheets have a Relative Thermal Index or RTI (see UL 746 B; IEC 61730-1) or RTE of at least 20°C above the maximum operating temperature of the PV modules, which is commonly 85°C or even 90°C (Desert conditions) or even 95°C (Building integrated modules). This means that backsheets need to keep at least 50 % of their initial tensile strength after typically 20.000 hours of thermal aging in an oven at 105°C (85 + 20 °C = 105°C), preferably 11.0°C (90 + 20 °C = 110°C) or even more preferably 115°C (95 + 20 °C = = 115°C). The RTI or RTE of the backsheet should be at least 105°C, preferably 110 °C, more preferably 115°C.

When looking to data's from the literature (e.g. Plastics Additives Handbook, 5^{th} edition,p. 81), it seems very difficult to achieve a RTI of 105°C or more with PA 6 based backsheet. Polyamide 6, although very cost effective is currently not used for backsheets. Only expensive types of polyamides, e.g. polyamide 11 or polyamide 12 are used for such application and backsheets thereof are supplied by e.g. Biosolar or lsovoltaic. Other requirements which are difficult to meet with Polyamide 6 are: good electrical insulation stability in humid conditions, UV stability, impact resistance, etc.

It is also required that the backsheet has a high rigidity in order to limit the deflection of the PV module under load (e.g. snow). FPP based backsheet may be not rigid enough.

It is also required that the backsheet has good dimensional stability during module production (vacuum lamination typically at 150°C and under pressure close to 1 atm). Polypropylene and Flexible PolyPropylene films or layers have the tendency to flow and shrink at 150°C and during cooling, leading to adhesion defects at the edges of the PV modules.

The present invention describes therefore also a very cost effective backsheet comprising preferably thermally stabilized (i.e including anti-oxidants) Polyamide based layer(s), possibly PA6 based layer(s), and thermally stabilized Flexible Polypropylene based layers, which can be combined in such a way that the resultant backsheet achieves a RTI or RTE of 105°C, even 110°C and even 115°C.

The Polyamide 6 based layer(s), if used, is/are protected by the FPP based layers which are laid at the backside of the backsheet (opposite side to the PV cells) in such a way that the Polyamide 6 based layer is protected from humidity and UV radiation. The FPP layer(s) allows also for easy welding to junction boxes, mounting accessories and/or framing.

Crystalline PV modules (C-Si), with the usual construction Glass / EVA / cells / EVA / backsheet may be sensitive to the phenomen of Potential Induced Degradation. Under Electric Field, e.g. sodium ions from the glass plate may migrate through the EVA encapsulant (especially in humid climate) and contact the front face of the PV cells, forcing electrons - holes recombination and loss of production of electricity.

The present invention describes therefore also a partly EVA or polar Polyethylene based front encapsulant comprising a layer on base of a non polar Polyethylene which limits sodium ions migration. The front encapsulant has still an excellent clarity, close to the one of EVA based encapsulants, and ease of crosslinking.

### SUMMARY OF THE INVENTION

It is the object of the present invention to limit the concentration of detrimental (by-) products, especially corrosive products released from encapsulants inside PV modules, especially to limit locally high concentrations of such detrimental (by-) products.

For this purpose, the invention provides insulating films with high permeability to this detrimental (by-) products, i.e. allowing this detrimental (by-) products to escape from the PV modules or at least to limit local high concentrations. The invention is particularly useful with backsheets with high permeability to detrimental (by-) products.

The invention further provides adapted encapsulants to limit generation of detrimental (by-) products and the phenomen of Potential Induced Degradation.

The invention further provides very cost effective backsheets with a.o. excellent acetic acid permeability, heat aging properties (RTI / RTE) and dimensional stability during module manufacturing.

The invention addresses especially the problem of generation and trapping of acid(s) within crystalline PV modules, where such modules comprise encapsulant material at least partly on base of EVA or at least partly on base of other acid generating material like co-Polyethylene (grafted) with acrylates, acrylic acids, maleic anhydrides.

To solve the object of the invention, one provides:
A) An electrical insulating film to electrically separate (insulate) conductive ribbons from other conductive parts of the PV modules, like PV cells, such a film having a high permeability to detrimental (by-) products (e.g. by micro-perforation or by being on base of permeable materials) preventing such (by-) products from being locally trapped,
B) Preferably encapsulants with reduced generation of detrimental by-products.

To extend the durability of PV modules at low cost, it is preferred to use a backsheet which is mainly based on Flexible PolyPropylene, i.e. a blend of Polypropylene (PP) and rubber (EPR, EPDM, VLDPE, ...), where the PP phase and the rubber phase are co-continuous (i.e. providing an InterPenetrated Network of PP and Rubber) or are nearly co-continuous (semi-interpenetrated). Such type of blend allows by-products to migrate, probably along the rubber network, outside the PV module and leads to much lower stresses on PV cells and interconnecting ribbons than PP (high rigidity - low relaxation of induced stresses).

The required quality of blend (a FPP blend by opposition to a PP blend) can be recognized and adapted by the man skilled in the art on base of cold foldability tests (according EN 495/5). The backsheet comprising FPP layers or at least the FPP layers, at least without fillers, should achieve a cold foldability temperature of at least -20°C, preferably -40°C or lower.

Such backsheets are described in patent application PCT/EP 2010/004335 ("Photovoltaic modules with Polypropylene based backsheet"), in European patent application N°: 10007553.0 ("Photovoltaic Modules using an adhesive integrated Heat Resistant multi-layer Backsheet") and in PCT/EP2009/000665 ("Photovoltaic modules and Production Process") which are incorporated herein by reference in their entirety.

To achieve high permeability to detrimental by-products like acetic acid., other polymeric materials and blends are also useful as base material for layers of backsheets and electrical insulating films, like Polyamide or Polyamide blends with Polyolefins, e.g. Flexible PolyPropylene. A good quality of blend of Polyamide and Polyolefin is achieved by the addition or use of functionalized polyolefin with e.g. maleic anhydride (reactivity with amides) or by adding a compatibilizing resin being a block copolymer of Polyamide and Polyolefins.

Polyamides, e.g. PA 6, 6-10, 11 or 12, are already useful as such as base material for layers of backsheets and electrical insulating films as they provide a good permeability to e.g. acetic acid. Nucleating agents may be added to the polymer to avoid excessive crystallinity.

A very useful and cost effective backsheet is also proposed. Such backsheet comprises at least one Polyamide based layer, preferably on base of cheap polyamide 6, advantageously in blend with polyolefins and at least one FPP based layer where the FPP layer(s) is/are highly thermally stabilized. The highly thermally stabilized FPP layer(s) is/are able to keep significantly more than 50 % of their mechanical properties during 20.000 hours at 105°C, even at 110°C and even at 115°C (Such layer has a RTI or RTE of 105°C or even of 110°C and even of 115°C according IEC 60216 (2001-07)).

When the contribution of the FPP layer(s) to the mechanical properties of the backsheet is dominant, it has been further discovered that after heat aging, 50 % of the mechanical properties of the complete backsheet (including the PA layer or layers) can be kept, even when the mechanical properties of the polyamide layer(s) is/are nearly completely lost.

The contribution of the FPP layer(s) to the mechanical properties of the backsheet is made dominant by either stiffening the FPP layer(s) with fillers or by reducing the mechanical properties (elongation at break) of the polyamide layer or layer(s). It has been discovered that after extreme degradation of the Polyamide layer(s) during heat aging, there is no delamination between the FPP layer(s) and the PA layer(s), meaning that the integrity of the backsheet is safeguarded.

So, it has so been discovered that by adding fillers, especially glass fibers, in the Polyamide layer(s) and/or FPP layer(s), after thermal aging at elevated temperature (20.000 hours at Temperature of 105 °C or more), the tensile strength of the backsheet can still be of at least 50 % of the initial value, without delamination of layers.

To increase the contribution of the FPP layers to the mechanical properties of the backsheet, the FPP layer(s) are preferably reinforced by fillers, e.g. by glass fibers, in such a way that the stiffened FPP layer(s) has/have the main contribution in the tensile strength of the backsheet.

Another way to increase the contribution of the FPP layers to the mechanical properties of the backsheet is to add fillers, especially glass fibers, in the polyamide layers. Such fillers will reduce the elongation at break of the polyamide layers (cutting effect).

Alternatively, a thermally more stable Polyamide can be used, like Polyamide 11 or 12 to produce backsheets having a RTI (UL 746 B) of 105°C or more. Addition of fillers may anyway still be required to limit initial mechanical properties (elongation at break). Blending with polyolefins is still useful for the dielectric properties and in this case, cost reduction.

The backsheet comprises preferably one or more polyamide based layer(s) acting as heat resistant anti-perforation layer(s) during the module production (lamination at typically 150°C) and thermally stabilized FPP based layers acting as insulating layers and having a RTI of 105°C or more. Thermally stabilized (F)PP tie-layers having preferably a RTI of 105°C or more are used as adhesive layers between the polyamide and the FPP layers.

It has been further discovered that a polyamide layer within the backsheet, facing the encapsulant films or layers, acts as barrier against migration of peroxides or other crosslinking agents from the encapsulants films. The (F)PP layers and their stabilizers are indeed sensitive (reactive) to such agents and such agents should also not be lost by migration from the encapsulant films and by unwanted reactions with the FPP layers and their stabilizers (otherwise a.o. the crosslinking quality may be impaired).

It has been discovered that the polyamide layer, facing the encapsulant layers, may not be heat stabilized in a classical way. Classical phenolic anti-oxidants lead to severe discoloration problems when cross-linkable encapsulant films are used (curing agent like peroxide attack of the phenolic group).

Copper / lodine PolyAmide stabilizer systems lead to delamination of the tie-layers (functionalized polyolefin) when cross-linkable encapsulant films are used (peroxide attack of the Cu/I system and subsequent hydrolysis of chemical bonds between tie-layers and polyamide).

Specific anti-oxidants are required, like HALS (see Plastics Additives Handbook 5th edition, p. 123 à 136) especially HALS 52 (Nylostab S-EED), and/or non phenolic primary anti-oxidants (amine based). Such abovementioned anti-oxidants are preferably used in combination with phosphite/phosphonite secondary anti-oxidants or other secondary anti-oxidants.

It is preferred to add especially the secondary anti-oxidants with the help of a preferably functionalized polyolefin carrier based master batch, to avoid excessive reactivity during extrusion.

It has been discovered that very specific phenolic anti-oxidant (ADK 80 supplied by Adeka, lrganox 245) lead to lower discoloration than classical phenolic anti-oxydants (Irganox 1098, Irganox 1010, ...).

It has been discovered that the FPP layers, together with the tie-layers, provide excellent electrical insulation. A system voltage (IEC 60664-1:2007) of 600 VDC can already be achieved from a total thickness of the FPP layers and tie-layers of only 100 µm.

It is possible to design FPP based backsheets and layers allowing a system voltage of more than 1000 VDC and even of more 1500 VDC. This is theoretically possible with classical backsheets (Tedlar ® / PET / Tedlar ®, etc.) by increasing their thickness. Very rigid backsheets are anyway produced on such base. With FPP based backsheet, by increasing the content of rubber, the Emodulus can be reduced, allowing the production of thicker backsheets with acceptable rigidity.

Because the thermally stabilized FPP layer(s) and the (F)PP tie-layers achieve a RTI or RTE of 105°C or more, the backsheet comprising such layers will be assigned a RTI or RTE of 105°C or more. If the complete backsheet doesn't achieve such RTI or RTE of 105°C or more, then to define the system voltage rating of the backsheet, only the layers achieving such RTI or RTE of 105°C or more will be taken into account, e.g. 600 VDC from a total thickness of the FPP layers and tie-layers of only 100 µm.

While the polyamide layer(s) bring(s) mechanical integrity during the lamination of the PV modules, the FPP layer(s) protect(s) the polyamide layer(s) against moisture ingress and UV aging and allows for excellent electrical insulation performances and partial discharge performances. The FPP layer(s) is/are like Polyamide, highly permeable to acetic acid. The FPP layer(s) is/are highly durable (thermal aging, UV aging, hydrolysis resistance) and resilient even at low temperature. The FPP layer(s) bring(s) excellent electrical insulation which is not reduced by development of impact crazes during aging (with as result a reduced partial discharge resistance), like it is the case for common Polypropylene.

It is also advantageous to stiffen the Flexible PolyPropylene layer(s) by addition of fillers (talc, glass fibers, glass beads, etc) as by such addition, following benefits are delivered:
i. As the Emodulus (rigidity) of such layers is increased, the deformation of PV modules (bending) under load (snow and wind load downwards ...) and subsequent cells and interconnectors stresses is reduced. The stresses linked to contraction of the backsheet when the PV module is submitted to cold temperature (-40°C ...) are anyway increased.
ii. Reduction of CLTE (Coefficient of Linear Thermal Expansion). By a reduced CLTE, the, on the PV cells applied contraction stresses, when the PV module is submitted to cold temperature (-40°C ...), are kept acceptable as the contraction forces of the backsheet are proportional to CLTE (reduced) * Emodulus (increased).
iii. Improvement of the dimensional stability and resistance to flow under heat and load (lamination temperature and pressure) of the backsheet. This means surprisingly that the EVA encapsulant in contact with the front layer (typically glass, ...) will better adhere to the edges and corners of the front layer. This beneficial effect is observed already at low level of loading (typically from 5 to 15 % weight of glass fibers).
iv. Improvement of Scratch resistance, especially by addition of glass beads

When the external layer of the backssheet (the layer at the backside of the PV module) is based on a FPP blend, especially on a FPP reactor blend, it is easy to weld components of the module (like framing, mounting hooks and junction box) to such backsheet.

The FPP layer(s) and polyamide layer(s) are preferably coextruded and attached to each other by polyolefin tie-layers. The resultant backsheet is in this case extremely cost effective, especially when the polyamide layer is modified (blend) with polyolefins to improve its electrical performances (partial discharge behavior).

To achieve excellent adhesion to encapsulant, the backsheet is preferably equipped at the encapsualnt side with a (co-)PE based tie-layer.

When the encapsulant(s) films is/are cured by e.g. peroxides (heat) and/or photoinitiators (UV), it is preferred that the backsheet contains a polyamide layer located between the encapsulants and the FPP layer(s) of the backsheet, in order to limit the amount of radicals which migrate to and attack the FPP layers and their anti-oxidants. Indeed FPP and its anti-oxidants are sensitive to radicals (cracking) and side reactions may lead to discoloration (especially in Heat Damp Test, i.e. a climatic aging test at 85°C 85 % relative Humidity - 1000 hours; according to IEC 60215 (2005-04) or IEC 61646 (2008-05)). Further, it is desired to keep the radicals inside the encapsulant to increase crosslinking quality and avoid interference with the FPP layers and their anti-oxidants.

The invention provides a very useful front encapsulant obtained by coextrusion of highly transparent polar co-polyethylene (e.g. EVA with a high amount of Vinyl Acetate) and non polar co-polyethylene (e.g; VLDPE). The EVA layers excel in transparency and compatibility with peroxides, photo-initiators and silanes, while the VLDPE layer provides a barrier to migration of Sodium ions and reduces the production of acetic acid of the encapsulant. Excellent adhesion between layers is obtained after crosslinking (especially peroxide crosslinking). Thanks to the crosslinking, VLDPE of low melting temperature can be used (e.g. Exact 8230), which improves transparency.

### DETAILED DESCRIPTION OF THE INVENTION

### Definitions:

PV cells: All types of PV cells may benefit form the invention, in particular crystalline PV cells. Back contact PV cells benefit in particular from backsheets with integrated adhesive and electrically insulating films embedded within soft Polyethylene (like Organic Block Copolymers (OBC); trade name, infuse ™ from The Dow Chemical Company) based layers

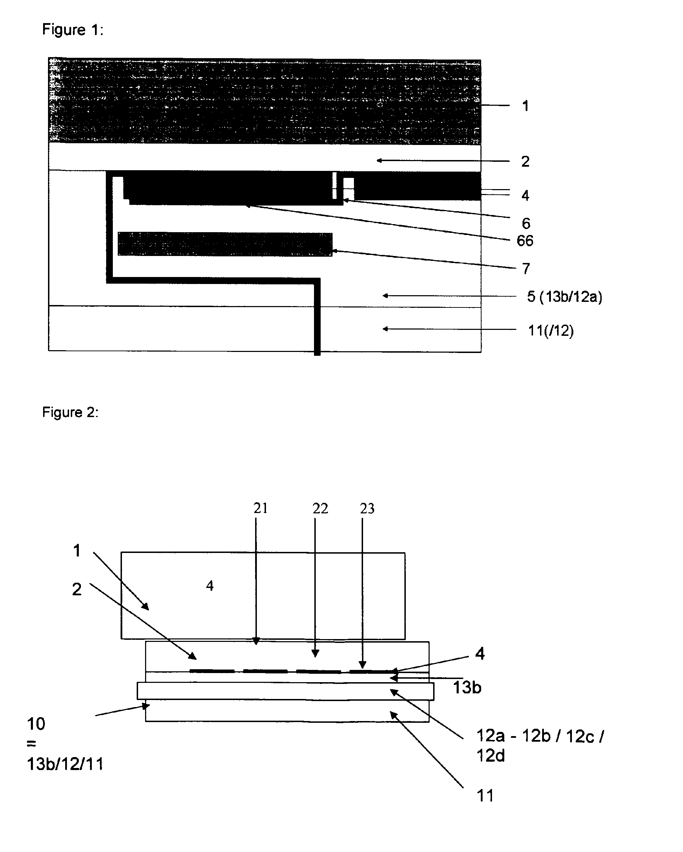

Flexible Polypropylene is a blend of Polypropylene (PP) and one of several elastomers or rubbers (EPR, EPDM, VLDPE, Elastomer PP...), where the PP phase and the rubber phase are co-continuous (i.e. providing an Interpenetrated Network of PP and Rubber) or are nearly co-continuous. Examples of suitable blends are:
i. Flexible polypropylene (FPP) mechanical or reactor blends of PP resins (homo or copolymer) with EPR rubber (ethylene propylene rubber), like "catalloy ®" reactor blends with as trade names Hifax CA 10 A, Hifax C212, Hifax CA 60, Hifax CA 02, Hifax CA 12 A, Hifax CA 138, Hifax CA7441A, etc. supplied by LyondellBasell.
ii. Thermoplastic vulcanisates blends like Santoprene base blends. Such thermoplastic vulcanisates are based on blend of PP, with EPDM rubber and are considered within the scope of this invention as PP/EPR blends, which are partly crosslinked.
iii. Mechanical FPP blends of PP resins with elastomer PP resins (like supplied by Dow under the trade name Versify 2300.01 or 2400.01),
iv. Mechanical FPP blends of PP with LLDPE (linear low densitiy polyethylene) or VLDPE (very low density polyethylene) plastomers (like Exact 0201 or Exact 8201 supplied by Dexplastomers), or copolymer of Ethylene with a polar comonomer like Vinyl Acetate or Alkyl Acrylates.
v. Blends obtained on base of 2 or more of the above mentioned blends.
   The amount of rubber (EPR, EPDM, Elastomer PP, VLDPE, etc.) in the PP - rubber blend is of at least 30 %, preferably of at least 40 %, more preferably of at least 50 % and even more preferably of at least 60 % weight of the PP - rubber blend.
   FPP reactor blends (produced by the catalloy® process, i.e. the reactor granule technology) are especially preferred as component of the backsheet as the rubber phase dispersion is excellent, which is key for a high diffusion of the detrimental by products through the backsheet outside of the PV module and for impact resistance (required to keep insulation properties).
   The amount of rubber can be estimated on base of comparative DSC analysis of the PP - rubber blend with the neat PP. While a Polypropylene will have a heat of fusion (DSC measurement; second heating at 10 K/minute)) of typically 100 to 110 J/g, the most useful FPP reactor blends will have a heat of fusion ranging from 15 to 60 J/g and of not more than 70 J/g, meaning a weight percentage of rubber phase typically from 40 to 80 % and of at least 30 %. The morphology (interpenetration) of such blend is well known in the art (see e.g. "Polypropylene: structure, blends and composites. J. Karger-Kocsis. Springer, 1995 - p 17, fig. 1.11)
Within the scope of this invention, the best ways to recognize a useful FPP blend based layer are by measurement of acetic acid permeability or by cold bending properties (cold foldability test according EN 495/5) of such film.
The acetic acid permeability measured at 60°C should be of more than 20 g/m^{2*}day for a film thickness of 0,5 mm (see test description later in the text).
The cold foldability of the film should be of at least - 20°C (-20°C or lower) and preferably of at least - 40°C (-40°C or lower). Common polypropylene based layers will not achieve such value.
These tests should be performed on a film without fillers.
Further, a FPP blend based layer having a cold foldability of - 20°C, preferably - 40°C will keep its electrical insulation properties even in cold climates.

(Co-) Polyethylene: Polyethylene (PE) is well known and may be copolymerized with several comonomers to produce (co-) PE. Useful comonomers are vinyl acetate, acrylate (e.g. butyl acrylate, ...), alpha olefins (octene comonomers like for metallocene VLDPE with as commercial example Exact 0203); etc. Organic Block Copolymers (Infuse) are a particular type of (co-)PE.

Polar co-PE is a co-PE comprising at least 10 % weight of polar comonomers like acrylates or vinyl acetates.

Non Polar co-PE is a co-PE comprising less than 10 % weight of polar comonomers, e.g. VLDPE (PE co alpha olefins).

Functionalized (co-)Polyethylene: To improve adhesion to e.g. the front layer, like glass, or with layers (PA based layers, etc), the (co-)Polyethylene may be functionalized by copolymerization or grafting of reactive functional groups, provided with an unsaturation (double bond). Examples of reactive functional groups provided with an unsaturation (double bond) are: maleic anhydride (reactive with Polyamide, EVOH, glass, ...), acrylic acids (reactive with Polyamide, EVOH, glass, ...), glycidyl methacrylate (reactive with MAH grafted polymers, PET, ...), vinylsilanes (VTMO) or other well known silanes like MEMO (reactive with glass, ...).

(Co-) Polyethylene Tie-layers are layers based on Functionalized (co-) Polyethylene.

(Co-)PolyPropylene Tie-layers are layers based on Functionalized (co-) PolyPropylene.

Flexible PolyPropylene Tie-layers are layers based on Functionalized Flexible PolyPropylene, e.g. a blend of Functionalized PolyPropylene and possibly functionalized rubber.

Functionalized means that the polymer is modified by grafting or copolymerization reaction with an unsaturated reactive group. The reactive group may be any chemical group providing adhesion by chemical reaction with the polymer it is designed to stick to. With polyamide or EVOH, the unsaturated reactive group will be preferably Maleic anhydride or an unsaturated acidic group (acrylic acid, ...).

PE-g-MAH means a PE grafted with maleic anhydride. PP-g-MAH means a PP grafted with maleic anhydride..

Transparent front layers used for this invention are based on glass or other transparent frontsheets (ETFE, PMMA ...), if required with adequate surface treatment like Plasma based treatment to graft adapted functionalities at the surface of the face of the front layer, coming into contact with Front encapsulant, if used.

When required, front encapsulants used for this invention are e.g. EVA films or other films releasing detrimental products. EVA is well known to release acetic acid. Such EVA film as upper adhesive layer is most generally a 0,46 mm thick film based on peroxide crosslinkable EVA (ethylene vinyl acetate), with a high fluidity (Melt Index (g/10m; 190°C; 2,16 kg) of more than 40) and comprising free silanes (i.e. not grafted before the lamination step of the PV modules). Useful EVA films formulation are e.g. described in WO 99/27588. They are well established as durable highly transparent adhesive layers. They are very useful to encapsulate thick crystalline Si PV cells (typically 250 µm) thanks to their ability to flow around the cells.

It is preferred to extend durability of adhesion with the front layer, in particular glass, that the side (face) of the front encapsulant coming into direct contact with the e.g. glass top layer, at least at the corner of the PV modules, is on base of a, before the lamination step of the PV modules, functionalized (co-)polyethylene, in particular with unsaturated silanes (MEMO, VTMO, ...).

It is also preferred that the front encapsulant comprises at least a layer close to or coming into direct contact with the e.g. glass top layer on base of co-PE of low fluidity (Melt Index (g/10m; 190°C; 2,16 kg) < 30, preferably < 10). This will reduce lateral flow (i.e. lateral movement of polymers when pressing the layers of the module together during the lamination step) of the encapsulant at the edges and corners of the front layer of the PV modules. Excessive lateral flow reduces adhesion.

Within the scope of this invention and to achieve a high light transmission and additives compatibility (additives retention: reduced exudation), the co-PE front encapsulant film (i.e. the film between the front layer, e.g. glass, and the PV cells), if such film is used, comprises preferably co-polyethylene layer(s) and at least one layer on base of polar co-PE like EVA with an high amount (> 20 % weight) of polar co-monomer (e.g. > 25 % of Vinyl Acetate comonomer), because such layer allows achieving excellent light transmission and additives compatibility (i.e. additives retention or in other words, limited exudation/blooming).

Other useful transparent polar co-polyethylene resins, useful to produce layers of encapsulant films, are EBA (Butyl Acrylate), EEA (Ethyl Acrylate), EMA (Methyl Acrylate) with an high amount of comonomer (higher transparency).

To improve adhesion to glass and/or metallic surfaces of encapsulant films, the external layers of such films are produced preferably on base of Silane (VTMO i.e. Vinyl TriMethoxySilane; MEMO i.e. Gamma-Methacryloxypropyl trimethoxysilane (silane Z6030 from Dow Corning)) grafted (co-)polyethylene (adhesion to glass), Maleic Anhydride grafted (co-)polyethylene (adhesion to metallic or oxide surface), Acrylic Acid grafted (co-)polyethylene (adhesion to metallic or oxide surface). Non hygroscopic co-polyethylene (VLDPE, LLDPE), by opposition to polar co-PE like EVA, are preferred as base for the silane grafted co-polyethylene, e.g. to limit the risk of partial crosslinking during storage.

To improve adhesion to glass of a more hygroscopic external layer (e.g. on base of polar co-polyethylene like EVA, EBA, ... ), grafting of silanes is not preferred. Ungrafted silane is preferably added to the composition of encapsulant films provided with such a more hygroscopic external layer or when the co-polyethylene of the external layer of the encapsulant film is not grafted with silane.

Usually crosslinking is obtained on base of peroxide (heat crosslinking) or by silane crosslinkers (humidity crosslinking) or on base of photoinitiators (UV crosslinking or curing). UV curing is an advantageous alternative (short cycles).

For heat (peroxide) or UV (photoinitiator), the encapsulant needs to contain a peroxide radicals initiator (DHBP, TBEC, ...Trade Name = Lupersol 101 or Lupersol TBEC) or a photoinitiator like benzophenone, methyl-benzophenone, phosphine oxides, etc. and in this latter case, the front layer needs to be sufficiently UV transparent (low iron glass, ETFE, ...). Usual multi-functional molecules (i.e. molecules provides with 2 or more unsaturations), also called crosslinkers, can be useful (e.g. allyl cyanurates like TAIC, TAC, ...) as they increase crosslinking density.

To reduce production of acetic acid, the front encapsulant can be of the structure EVA / VLDPE, i.e. a co-PE where the comonomers are alpha olefins (no generation of acids) / EVA (more generally comprising one or more polar co-PE based layer and one or more non polar co-PE based layer).

The polarity of EVA (or of polar co-PE) allows avoiding exudation of several additives like silanes, peroxides, crosslinkers (TAIC) and especially of photoinitiators, like Benzophenone or phosphine oxides, from the front encapsulant. Above mentioned molecules are relatively polar molecules and therefore insufficiently compatible with VLDPE, but sufficiently with EVA (or other polar co-polyethylene like EBA ...) to avoid exudation. Exudation will deteriorate adhesion.

A polar co-PE layer or layers are therefore desired for the purpose of additive retention and easier curing.

The layer(s) of the encapsulant may contain one or more photoinitiators, like Benzophenone (BP), Methyl Benzophenone (MBP), phosphine oxides types, etc, which different UV absorption edges to in crease the depth of curing.

Following coextruded film structure is very useful: EVA based layer with cross-linking initiator / VLDPE based layer / EVA based layer with cross-linking initiator, each layer, especially the external layers, preferably comprising usual additives like thermal and UV stabilizers, adhesion promoters (silanes, possibly grafted), etc. The additives (cross-linking initiator, silanes, ...) are added to the layer self or are provided by migration from other layers. Peroxides are preferably added to thick layers (low shear and risk of premature crosslinking).

The less polar VLDPE layers can contain additives which are less compatible with EVA.

Alternatively, the structure can be "Functionalized (especially silane grafted, for adhesion to glass) VLDPE / EVA with photoinitiator(s)/ Functionalized VLDPE".

It has been also discovered that although the initial adhesion between polar co-PE, especially with a high amount of polar co-monomer, and non polar co-PE is poor, after cross-linking, the adhesion is much improved and sufficient.

The inclusion in the front encapsulant of a VLDPE layer will also reduce the phenomen called Potential Induced Degradation (PID) as such layer is nonpolar and, as a result, ionic mobility within such layer will be low.

When the front encapsulant is (partly) cured (e.g.) by UV curing and/or by the help of silane crosslinkers, its crystallinity will be reduced and the film will become more transparent. Further, co-PE with lower melting temperature, and therefore lower crystallinity can be selected, with as result improved transparency.

Premature (i.e. during storage) crosslinking of silane functionalized external (co-)PE layer(s) has to be avoided because this will deteriorate the adhesion to glass and the encapsulation process of the PV cells. Therefore, only a low amount of condensation catalyst (DBTM, DOTM...) should be incorporated into the encapsulant film. To address the issue of premature crosslinking and to ease the co-extrusion process, a multi-layer structure is preferred, like following one:
i. Silane grafted co-PE, preferably VLDPE, based layer for adhesion to glass
ii. One or more Co-PE based layer(s)
iii. A Co-PE based layer with condensation catalyst
iv. One or more Co-PE based layer(s)
v. Functionalized (co-)PE for adhesion to PV cells

During the production of the PV module, the condensation catalyst will migrate and trigger crosslinking of at least layer i (silane crosslinking) and possibly layer v if provided with silane crosslinkers (silane functionalized).

The layers ii, iii and iv may be on base of EVA (or other polar co-PE) with cross-linking initiator(s). During or after production of the module, heat or UV curing (or visible light curing) is applied, in the latter case through the solar glass, preferably while the PV module is still hot, to cure at least layer ii, iii and iv.

Layers ii, iii, iv may alternatively be relatively thin layers and on base of (co-)PE with an higher melting temperature than maximal use temperature

Preferably, Layers ii, iii, iv are based on EVA (or other polar co-PE) of lower melting temperature than the maximal use temperature (i.e. on base of a polar co-PE of low crystallinity and therefore high transparency) and provided with a photoinitiator and crosslinked by UV or visible light after module production.

The condensation catalyst may also be added in the (co-)PE based layers of the backsheet and will migrate to the encapsulant layers during module production to trigger crosslinking.

The rear encapsulant can be EVA but may be based on material with low release of detrimental product, e.g. on base of (co-)PE where the comonomers are alpha olefins (no generation of acids), even if such (co-)PE generally lead to slightly less transparent films.

"Mainly TPO based backsheets possibly including a rear encapsulant layer" are described in patent applications PCT/EP 2010/004335 ("Photovoltaic modules with Polypropylene based backsheet"), PCT/EP2009/000665 ("Photovoltaic modules and Production Process"), and in European patent application N°: 10007553.0 ("Photovoltaic Modules using an adhesive integrated Heat Resistant multi-layer Backsheet"). The backsheets described in those applications are all useful for the present invention.

For the present invention, preferred backsheets comprise:
i. Possibly a tie-layer in contact with the backside (electrical back-contact, ...) of the PV cells, on base of a functionalized (e.g. by grafting or copolymerizing a functional group like a silane or a maleïc anhydride or an acrylic acid, or a glycidyl methacrylate, ...) co-polyethylene, such functional group selected to achieve a good adhesion to the backside (electrical back-contact, ...) of the PV cells. Further, the (co-)PE is preferably on base of alpha olefin comonomers (no generation of acids) or of OBC.
ii. Possibly a preferably soft (co-)polyethylene based layer selected (softness, melt index, thickness) to achieve a good encapsulation of e.g. thick crystalline silicon cells. The thickness and fluidity will be increased in case of thick PV cells. The (co-)PE is preferably on base of alpha olefin comonomers (no generation of acids).The softness may be increased to limit mechanical damages to thin and brittle PV cells, like crystalline PV cells of low thickness (< 200 µm) and to their interconnection (weak solders of e.g. back contact solar cells). OBC co-PE is a useful material as component of this layer to increase softness (especially at low temperature). Lamination temperature is adapted to the melting temperature of the encapsulant film and vice versa, i.e. pressure is applied only when the polymers are melted.
iii. Possibly one or more connecting layers allowing achieving good adhesion between the rear encapsulant like EVA or like co-polyethylene based layer(s) and the mainly FPP based layer(s)
iv. a mainly Flexible PolyPropylene based layer, being possibly a multi-layers layer comprising possibly at least one layer with higher heat resistance (e.g. a layer on base of a homopolymer PP blend and/or provided with glass fibers or glass beads) to keep mechanical integrity during lamination temperature (typically 150°C). PA or PA/PP or PA/PE blends, usefully with glass fibers and/or beads, based layer may also be included (with the help of intermediate polyolefin based tie-layers) for such purpose. Such layers are selected in thickness and in composition to allow for a high acid permeability.

Layer i and/or ii may be (partly) cross-linked e.g. by humidity e.g. in use and the co-PE base material of such layers will be equipped (reactive extrusion) with silane crosslinkers (grafted silane like MEMO or VTMO). Such layers may also be multi-layers layers comprising layer(s) without silane crosslinkers and at least one of such layers is provided with a condensation catalyst.

Connecting layers may be provided between the mainly Flexible PolyPropylene based layer and the rear encapsulant layer(s), typically EVA, and can be:
- option 1) a TPO mixture based layers or layer creating an interpenetrated network of VLDPE and PP (based e.g. on a mixture of VLDPE, FPP reactor blend and PP elastomer). Such layers may be partly crosslinked to improve inter-layer adhesion
- option 2) a 3-layer reactive system, being "a (co-)PE-g-MAH based tie-layer / a PA or a EVOH based film layer or a Polyester based film layer (PET, PBT, ...)/ a thin PP-g-MAH based tie-layer, preferably in blend with (functionalized) rubber like EPR rubber" to increase permeability to detrimental by-products like acetic acid through this layer.

Combination or blends of PA (layers) and EVOH (layers) are further possible and useful when improved oxygen barrier properties are required.

The PA based layer can be further based on a blend of PA / (F)PP or PA / PE, where the (F)PP or the PE is partly functionalized, for good adhesion to and dispersion into the PA phase, with e.g. maleic anhydride (by reactive extrusion). Blending with (F)PP and/or PE increases oxygen permeability of the backsheet, which may be useful for building passivated oxide layers (corrosion protection) within the PV module and/or for bleaching of encapsulant films or layers like EVA based encapsulant films or layers.

To achieve a high permeability to oxygen, preferred polyamide are polyamides with a longer CH2 sequence than for Polyamide 6. A useful polyamide is polyamide 12

Other tie-layers may be used (e.g. PE co Glycidyl Methacrylate PE-GMA), especially with PET or PBT. Such layers are preferably microperforated to increase permeability (being understood than the dielectric FPP layers are not)..

Other combination can be derived like: microperforated PE-GMA based tie-layer (i) / preferably microperforated Polyester based layer (ii) / PE-GMA based tie-layer / PP-g-MAH based tie-layer / FPP based layers, being understood that the microperforation is limited to layers (i) and (ii).
- option 3) a 2-layer reactive system, being "a PE-GMA copolymer based layer / a PP-g-MAH based layer". See for more details US 2010/0108128 A1 (coextruded, multilayered polyolefin-based backsheet for electronic device modules)).
   Option 2, in particular inclusion of a polyamide based layer, is preferred to improve the heat resistance of the PV module package (avoid the risk of perforation of the backsheet by the bus bars and solder points during module lamination) and avoid migration of components (e.g. peroxides) of the encapsulants into the FPP layer(s).

To improve heat resistance and dimensional stability during lamination, to reduce mismatch of thermal expansion coefficient between layers, especially FPP and PA based layers), to increase stiffness (especially of FPP layers) while reducing the CLTE, to reduce lateral flow during module lamination (under pressure and heat) and poor adhesion to the front layer (glass, ...) of the front encapsulant at its edges and corners, and to improve reaction to fire of the backsheet, glass fibers or other mineral particles (talcum, ..) may be added in one or more layers of the backsheet, preferably at least in the FPP main layer.

The FPP based layers without glass fibers/beads are soft and have indeed a high coefficient of linear thermal expansion (CLTE) of typically 150 10⁻⁶ m/m K. Addition of glass fibers/beads in FPP based layers allows a reduction of CLTE typically of a factor 2 or more. Addition of glass fibers/beads in FPP based layers increases their Emodulus typically of a factor 2 or more. Acetic acid permeability is anyway kept by such addition and low temperature contraction forces are still by far lower than for Polypropylene.

Addition of typically 5 to 15 % of fibers or more, especially glass fibers, in FPP based layers reduces surprisingly the tendency of the EVA front encapsulant to be much expelled from the PV module, during and after module lamination (typically 150°C 15 minutes and under 1 bar pressure), at the edges and corners of the PV module, leading to adhesion defects of EVA to the front layer (especially glass) in these critical areas (edges and corners). The same effect is achieved with a lower amount of (glass) fibers provided other fillers are added like glass beads.

Fillers having a plate shape, like talcum, mica, etc., are useful to reduce the water vapor permeability if needed, but will also reduce acetic acid permeability.

Glass fibers may in some extent increase acetic acid permeability and water vapor permeability. The length of the glass fibers is preferably less than 1000 µm and more preferably less than 600 µm to limit risk of capillarity along the fibers. The glass fibers are surface treated especially by amino-silanes and the FPP contains preferably a functionalized PP, e.g. a MAHgrafted PP to improve adhesion of the silane treated fibers to the FPP matrix (amine - MAH reaction).

A mixture of (e.g. glass) fibers and glass beads or other fillers is also very beneficial to improve dimensional stability and increased the E-modulus. The advantage of a mixture of glass fibers and e.g. glass beads compared to the same amount of glass fibers alone is the improved processability (extrusion) the polymer blend.

The last layer of the backsheet, facing the junction box, may be without glass fibers, to avoid water ingress risk (capillarity along the glass fibers).

Further, to improve thermal stability (retention of mechanical properties during aging at elevated temperature, i.e. e.g. to achieve a relative thermal index or endurance of (layers of) the backsheet of more than 90°C, preferably of more than 105°C, anti-oxidants are required.

Polyamides with better intrinsic thermal stability like PA 11 or PA 12 are useful

A cost effective very useful layer (heat resistance - reduced risk of perforation) is a Polyamide 6 based layer. Poor thermal stability of Polyamide 6 and sensitivity to humidity (meaning a.o. very poor dielectrical performances) and UV aging don't allow the use of PA 6 as base component of backsheet alone. It has been discovered that a PA 6 based layer may be used when protected by layer(s) with good electrical properties, water barrier properties, UV and thermal durability and cold impact mechanical properties. A very effective protection and dielectric layer is a UV stabilized and heat stabilized FPP based layer(s).

Blending the polyamide with polyolefins (using preferably compatibilizing resins) allows also for a reduction of the dielectric constant of the polyamide. A reduced dielectric constant means a better resistance to the phenomen of partial discharge, as the electric field around defects will be reduced. This means that thinner layers may be used for the same System Voltage rating of the backsheet.

Adhesion of the (F)PP based layer(s) to the PA based layer(s) is preferably provided by a PP based tie layer (e.g. PP grafted MAH) by coextrusion. The PP based tie layer preferably comprises rubbery material (EPR, EPDM, VLDPE, Elastomer PP, ...) to improve permeability to acetic acid.

The heat stabilizer package of the FPP based layer(s) preferably comprises a phenolic anti-oxidant, and a phosphite or phosphonite and more preferably a phenolic anti-oxidant, a phosphite or phosphonite and a sulfur compound (thiosynergist). Classical (non low gas fading) very effective anti-oxidants like lrganox 1010 may be used to stabilize the FPP based layers as the polyamide based layer acts as barrier against the migration of the peroxides or photoinitiators from encapsulation films towards the FPP based layers.

Useful Anti-oxidants a.o. to improve the thermal stability of Polypropylene are described in Plastics Additives Handbook 5^{th} edition, p. 40 and following: A thermal stability of PP plaques (1 mm) of up to 80 days (11 weeks) at 150°C - see p.54 - can be achieved on base of combination of phenolic, phosphite and thiosynergist anti-oxidants. Taking into account an activation energy of 106 kJ/mole, this means a RTI of typically 120°C or more. When the FPP based layer is highly filled, araldite 7072 may be added to the formulation to further improved heat stability.

On the other hand (see p. 81), Polyamide 6 plaques (1 mm) can't achieve a long term thermal stability (20.000 hours) of even 100°C. 90°C may well be achieved.

It has been discovered that a backsheet comprising a polyamide a.o. a polyamide 6 based layer (or layers) may achieve a RTI or RTE (i.e. typically keeping more than 50 % of the initial tensile strength after 20.000 hours) of 105°C, even 110°C and even 115 °C when such PA based layer(s) is (are) combined with FPP based layers (and PP based layers) designed a.o. by addition of fillers in such a way that they dominate in the tensile properties of the backsheet.

The present invention defines several ways to achieve dominance of FPP based layers (and PP based layers) in the tensile strength of the backsheet.

Layers are preferably designed in such a way that the tensile strength and/or the Emodulus (tensile test according Iso 527-3) of the FPP and PP based layers (including the PP tie layer(s)), multiplied by their total thickness is not less than 50 %, preferably not less than 75 %, most preferably not less than 100 % of the tensile strength of the polyamide based layer(s) multiplied by its (their) total thickness.

In such a way, the contribution to tensile strength of the (F)PP based layers can be enough to allow keeping a tensile strength of at least 50 % of the initial value of the backsheet, even when the polyamide based layer(s) have lost nearly completely their mechanical properties.

It is possible to increase the Emodulus of the (F)PP based layers by addition of fillers (talcum, glass beads, mica, (glass) fibers, magnesium hydroxide, aluminium hydroxide, calcium carbonate ... or combinations) and/or by a lower amount of rubber in the FPP blend.

It is possible to reduce the Emodulus of the polyamide based layers by addition of plasticizing/impact modifying resins or rubbers or plasticizers or combinations thereof.

Several means are possible to reduce the Tensile strength (by reduction of the elongation at break) of the Polyamide based layer, such as higher filler loading (talcum, glass beads, mica, glass fibers, magnesium hydroxide, aluminium hydroxide, calcium carbonate ... and combinations).

It has in particular been discovered that by increasing the E modulus and tensile strength of the thermally stabilized FPP layers, by addition of glass fibers or other fillers (glass beads, talcum, mineral fibers ...) in the FPP layers, i.e. by increasing the relative contribution of the FPP based layer(s) to the tensile strength of the PA/FPP based backsheet, the loss of tensile strength can be kept limited to less than 50 % during 20.000 hours at a temperature of 105°C, even 110°C and even 115°C.

More specifically, it has been discovered that the several PP and FPP based layers of the backsheet should be filler reinforced in such a way that they achieve a maximum tensile strength for an elongation which is closed to the yield point of the polyamide layer(s), i.e. for an elongation of typically 10% (between 5 % and 30 %). This means practically that the FPP layers are stiffened and their Emodulus come close to the E modulus of the polyamide layers of the backsheet.

It is anyway preferred to select FPP layers having a E-modulus as close as possible to the E-modulus of the Polyamide layer(s) while still having a high content of rubber (better acetic acid permeability, cold impact properties, stress relaxation properties) in the FPP material. Stiffness and high rubber content are of course contradictory.

Adding fillers like glass fibers to the composition of the FPP layer(s) with high rubber content is therefore preferred. Addition level of glass fibers will be typically between 2 and 50 % weight, preferably 5 and 40 % weight, more preferably 8 to 30 % weight of the FPP layers. Addition of talcum and other platelike fillers is possible but not preferred because of a negative impact on permeability (reduced permeability to acetic acid). Addition of glass beads to replace partly glass fibers is useful for the processing (extrusion)

Addition of fillers e.g. glass fibers to the polyamide layer(s) leads to a reduction of the tensile strength and elongation of the Polyamide layer(s). By such addition, the contribution of the Polyamide layer(s), to the tensile strength of the backsheet, is reduced. A better relative retention after heat aging of tensile strength of the backsheet can therefore (partly) be achieved in such a way. Indeed, the mechanical properties of the polyamide layer being initially reduced (poor initial elongation), by addition of the fillers, like glass fibers, the relative loss of tensile strength after aging of the backsheet will be lower, being understood that the FPP based layers keep their mechanical properties thanks to their excellent thermal stability as a result of addition of suitable anti-oxidants.

Inorganic flame retardants (Magnesium or Aluminium Hydroxide, ...) are useful to reduce flame spread of the backsheet.

Further such fillers (more generally fillers having reactive hydroxyl (OH) groups available), have a positive impact on (increase) acetic acid permeability. More precisely, they improve extraction of acetic acid from the encapsulant films as they are able to react with migrated acetic acids, keeping a high diffusion gradient between encapsulant films and backsheet. It is preferred to add such fillers in layers of the backsheet which are close to or in contact with the encapsulant films.

Pigments, especially TiO2, are useful, in all layers, to increase the solar reflectance of the backsheet.

To achieve good adhesion with co-polyethylene based encapsulant layers, the polyamide based layer is preferably also coextruded at the cells facing side with a (co-)PE tie layer. Such layer provides also good adhesion to the aluminium frame if such is used.

To avoid premature degradation of the tie-layers, the Polyamide layer will preferably not be stabilized with classical Cu/I based Polyamide stabilizers. Such stabilizers are well known to provide to polyamide a RTI of 105°C or more. Such anti-oxidant package is further of the type "low gas fading (no phenolic included)" but the Cu will catalyze polyolefin thermal degradation and the Iodine (I) will lead, especially after reaction with migrated peroxides, to hydrolysis of the bonds between the PA layer and the tie-layers. Delamination is observed after a short period of time (typically < 1 week immersion in water 80°C).

A useful approach can be to encapsulate the Cu/I stabilized PA based layer between two non Cu/I (e.g. Nylostab S-EED stabilized) stabilized PA based layer

Adapted anti-oxidant package needs to be selected especially for the PA based layers acting as barrier layer against radicals migration (crosslinking agents) and for the (co-)PE tie layer coming in contact or submitted to the radicals migrated from the encapsulant layers (EVA ... comprising radical generating products).

Classical phenolic anti-oxidants lead to severe discoloration after reaction with migrated peroxides when the PV modules are submitted to the Damp Heat Test (aging 1000 hours at 85°C, 85 % Relative Humidity). To avoid discoloration as a result of the reaction of anti-oxidants of the backsheet with activated migrated radicals initiators (peroxide or photo initiators ...) from the encapsulant layers and by further hydrolysis reactions by humidity and heat (Damp Heat Test i.e. climatic test at 85°C ,85 % relative humidity), low gas fading anti-oxidants are preferred especially in the Polyamide and (co-)PE based layers (the most submitted to radical attack by migrated radicals from the encapsulant films). Such anti-oxidants are secondary anti-oxidants like phosphites or phosphonites, hals and specific phenolic anti-oxidant of the type low gas fading, like Adeka AO 80 and blend thereof.

Other very suitable anti-oxidants for Nylon are the "Nylostab S-EED" family (supplied from Clariant), possibly in blend with phosphites and other Hals. Such anti-oxidants and blend thereof provides a good heat aging of the polyamide layer at 90°C or more. The polyamide layer will achieve therefore a RTI of 90° C or more.

A multi-layer PA6 based layer with a core or main PA6 based layer stabilized with a Cu-I based anti-oxidant system and at least one external layer (in contact with the functionalized PE based tie-layer) stabilized on base of another type of anti-oxidant like e.g. "Nylostab S-EED", will achieve a RTI of more than 105°C. Useful Cu-I based anti-oxidant system are sold by e.g. Brueggemann under the trade name Bruggolen ® e.g. TPH 6010. In such a case, the (co-)PE tie-layer is protected from degradation by the Cu-I system (non Cu-I based stabilized intermediate-separation Polyamide layer).

Anti-oxidants and Hals are further described in Plastics Addtitives Handbook.

As the thermally stabilized FPP based layers, especially layers without fillers, provide excellent electrical insulation and have a RTI of 105°C or more, a system voltage (IEC 60664-1:2007) of at least 600 VDC can be achieved at a RTI rating of 105°C or more by the inclusion into the backsheet of thermally stabilized FPP based layers of a thickness of only 100 µm or a bit more.

Heat Stabilzed (F)PP based tie-layers contribute also to electrical insulation and have a RTI of 105°C or more.

By coextrusion of heat stabilized FPP based layers with a thermally stabilized Polyamide 6 layer, the system voltage (IEC 60664-1:2007) of the obtained backsheet will be increased to possibly 1000 VDC, but only for a RTI rating of 90°C or only slightly more (< 105°C) because the Polyamide 6 based layer is not thermally stable enough at 105°C to be considered as providing electrical insulation for a 105°C RTI rating or more.

The combination of heat stabilized FPP based layers and heat stabilized PA 6 based layers is anyway very useful, because PV modules requiring a system voltage of 1000 VDC are used for solar farms where a RTI rating of 90°C is generally sufficient and PV modules requiring a RTI rating of 105°C or more are used mainly for little systems (roof top - building integrated) requiring a lower system voltage than 600 VDC.

Because Flexible PolyPropylene is an excellent dielectric and is flexible compared to PET, it is possible to produce thick backsheets (typically 0,6 mm) with a system voltage of 1500 VDC or more. In such thickness PET is very stiff and difficult to process without defect (poor lamination).

To avoid undesired reactions of the anti-oxidants during extrusion, it is preferred to add the anti-oxidants to the polyamide with the help of a polyolfin based master batch, preferably a functionalized polyolefin based master batch.

To solve the problem of locally high concentration of detrimental (by-) products leading to blistering and/or corrosion, the invention provides a possibly multi-layer based electrical insulating film which is highly permeable to such detrimental products. A convenient way to achieve the high permeability is micro-perforation of the film. Classical well known films are the so called "Tedlar ® / PET / Tedlar ®" or "PE / PET / PE", where Tedlar ® is a surface treated PVF film and PE is a PolyEthylene (possibly copolymerized with a low amount of Vinyl Acetate (< 10 % weight VAc)) based film.

Preferably the core of the film is based on Polyamide, like polyamide 6, 11 or 12 or blends of polyamide with preferably (flexible) Polypropylene or Polyethylene, functionalized for compatibility with polyamide.

Preferably, such electrical insulating film is adhered (embedded) to adjacent layers on base of material which doesn't release significantly detrimental (by-) products. A preferred structure (embedded electrical insulating film) is produced by coextrusion and is as follows:
- (Co-)PE tie-layer with similar composition as the optional (Co-)PE tie-layer of the backsheet, coming into direct contact with the backelectrode of the PV cells. The (co-)PE is preferably on base of alpha olefin comonomers (no generation of acids).
- soft (co-)PE with similar composition as the optional (co-)polyethylene based layer of the backsheet. The (co-)PE is preferably on base of alpha olefin comonomers (no generation of acids). The softness may be increased to limit mechanical damages to thin and brittle PV cells, like crystalline PV cells of low thickness (< 200 µm) and to their interconnection (weak solders of e.g. back contact solar cells). OBC co-PE is a useful material as component of this layer to increase softness (especially at low temperature).
- (Co-)PE tie-layer with similar composition as the optional (Co-)PE tie-layer of the backsheet, coming into direct contact with the PA based layer described next. The (co-)PE is preferably on base of alpha olefin comonomers (no generation of acids).
- PA based layer or PA / (F)PP or PA / PE blend based layer where the Polyolfin ((F)PP or PE) is functionalized for good adhesion to and dispersion into the PA phase, e.g. with maleic anhydride
- (Co-)PE tie-layer with similar composition as the optional (Co-)PE tie-layer of the backsheet
- soft (co-)PE with similar composition as the optional (co-)polyethylene based layer of the backsheet. The (co-)PE is preferably on base of alpha olefin comonomers (no generation of acids).The softness may be increased to limit mechanical damages to thin and brittle PV cells, like crystalline PV cells of low thickness (< 200 µm) and to their interconnection (weak solders of e.g. back contact solar cells). OBC co-PE is a useful material as component of this layer to increase softness (especially at low temperature).
- (Co-)PE tie-layer with similar composition as the optional (Co-)PE tie-layer of the backsheet being a functionalized (co)PE based tie-layer for adhesion to the conductive ribbon.

The invention will be illustrated further by reference to the attached drawings which are not meant to restrict the scope to the specific embodiments shown. Other combinations of the preferred features than those shown are also possible and advantageous. It should be appreciated that for simplicity and clarity of illustration, elements shown in the figures have not necessarily been drawn to scale.

Figure 1 shows a cross section of a PV module showing:
- a front layer like a glass plate (typically a 3,2 mm low iron tempered glass) (1)
- a transparent upper adhesive layer (2), e.g. a film of EVA Vistasolar 486.10, 0,46 mm or a multi-layer film of a structure like EVA/VLDPE/EVA, comprising radicals initiators (like peroxides or UV photoinitiators) and/or grafted silanes crosslinkers to achieve crosslinking (by heat or UV or humidity) during or after lamination and comprising usual additives (HALS, anti-oxidant, possibly UV absorbers, possibly anti-acid, possibly crosslinkers of the type TAIC or multi-acrylates etc.).
- PV cells (4)
- a rear encapsulant (5) (EVA or a tie-layer (13b) / soft co-PE layer (12a)).
- a mainly FPP backsheet (11) with possibly connecting layers (12)
- a interconnecting conductive ribbon (6)
- an insulating film (7)
- a local zone of risk of corrosion (66), where detrimental (by-)products can be trapped, e.g. acetic acid, especially when film 7 is embedded in EVA films.

Figure 2 shows a cross section of a PV module with
i. a front layer glass plate (1)
ii. a transparent upper adhesive layer (2), e.g. a film of EVA Vistasolar 486.10, 0,46 mm or a multi-layer film of a structure like EVA/VLDPE/EVA, comprising radicals initiators (like peroxides or UV photoinitiators) and/or grafted silanes crosslinkers to achieve crosslinking (by heat or UV or humidity) during or after lamination and comprising usual additives (HALS, anti-oxidant, possibly UV absorbers, possibly anti-acid, possibly crosslinkers of the type TAIC or multi-acrylates etc.).
iii. active layers (4)
iv. e.g. a rear encapsulant (5) (EVA) and a mainly FPP backsheet (11) with possibly connecting layers (12) or a mainly TPO based backsheet with e.g. integrated adhesive (10) comprising:
   1. a functional (co-)PE tie-layer (13b) with good adhesion to active layers (4) back-electrode or back barrier or back primer coating and to adhesive layer (2),
   2. if desired, a possibly multi-layer encapsulating layer (12a), having appropriate softness and melting temperature to limit stresses on active layer(s) (4), adequate viscosity and thickness to encapsulate possibly thick active layer(s) like crystalline silicone PV cells (4).
   3. if required connecting layers (12b) (12c) (12d) ...
   4. a backsheet (11) e.g. based on a multi-layer (F)PP based layer.

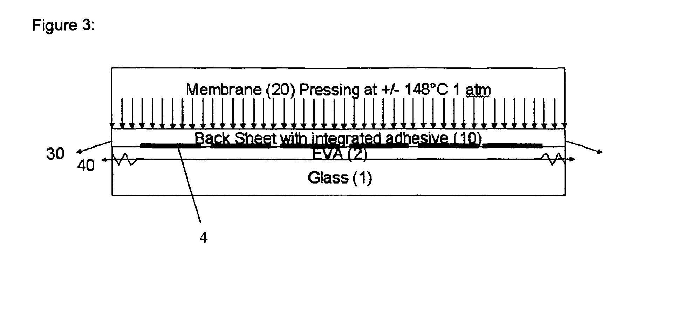

Figure 3 shows a cross section of a PV module being laminated in a classical membrane (20) press:

The cross-section shows:
- a glass plate (typically a 3,2 mm low iron tempered glass) (1)
- a co-PE based front encapsulant (2), e.g. a film of EVA Vistasolar 486.10 - 0,46 mm, especially a film with low melting temperature (typically < 100 °C) and high fluidity (Melt Index > 3 g/10minute; 190°C; 2,16 kg).
- PV cells (4)
- An adhesive integrated backsheet (10) or rear EVA (5) - Backsheet (11), preferably with connecting layers (= 10).
- A membrane (20) pressing the several layers (1, 2, 4, 10) together at a temperature of +/- 145°C, with a pressure between 0,5 and 1 bar,.and leading to lateral flow (see arrows 30) of the backsheet (10) and mainly of the front encapsulant layer (2), with as result poor adhesion (40) between glass (1) and front encapsulant (2): Under such pressure and temperature, the front encapsulant adhesive (2) is expelled (30-40) and ripped (40) from the glass plate (1) at the edges and corners of the PV module. Such problem is reduced when the Backsheet (11 or 10), especially FPP layers, comprises fillers, especially glass fibers, especially of typically from 5 to 1000 µm length, preferably 100 to 500 µm length.

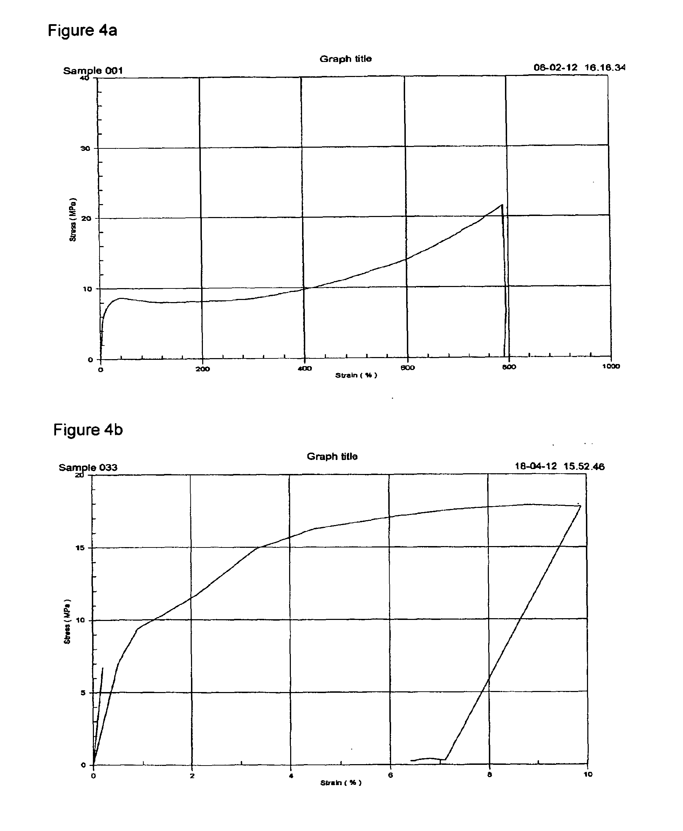

Figures 4a) to 4e) show tensile strength graphs of:
Figure 4a) a Flexible PolyPropylene based layer

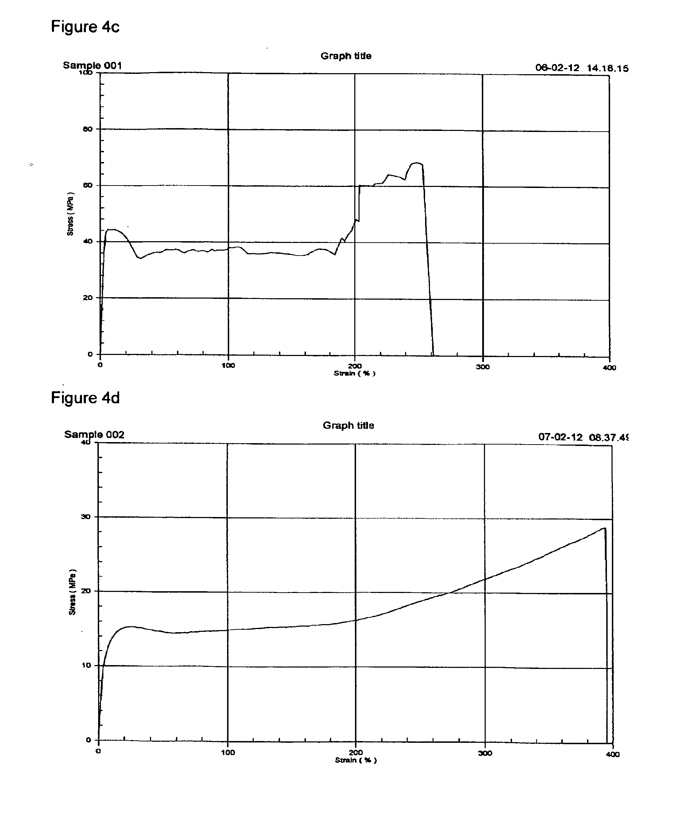

Figure 4b) a layer based on the same Flexible PolyPropylene as 4a) but reinforced with glass fibers (12 % glass fibers) in such a way that the FPP layer has a much higher tensile strength contribution to the backsheet at typically 10 % deformation (Polyamide yield zone) Figure 4c) Polyamide 6
Figure 4d) A multi-layer structure: 50 µm PEgMAH / 75 µm Polyamide 6 / 25 µm PP gMAH/ 200 µm Flexible PolyPropylene (material from 4a).

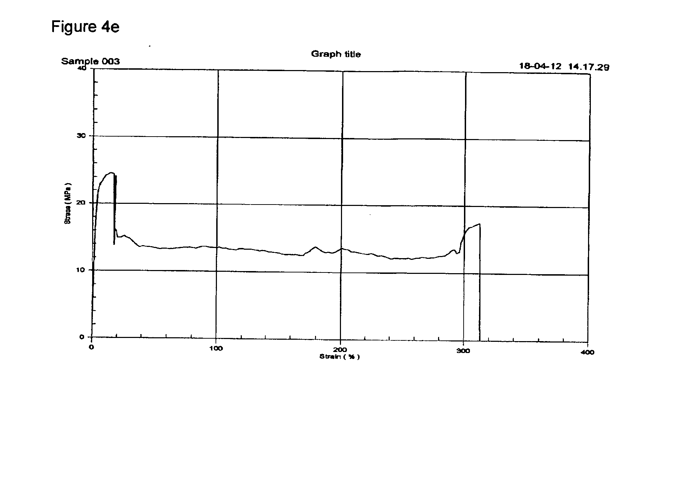

Figure 4e) A multi-layer structure: 50 µm PEgMAH / 75 µm Polyamide 6 / 25 µm PP gMAH/ 200 µm Glass reinforced Flexible PolyPropylene (material from 4b).
In figure 4d), the polyamide layer acts as reinforcing layer. When such layer loses its mechanical properties after heat aging, the full backsheet has poor mechanical properties (less than 50 % of the initial tensile strength).
In figure 4e), the glass reinforced flexible polypropylene layer dominates in the tensile strength properties of the backsheet. Even when the polyamide layer loses its mechanical properties after heat aging, the full backsheet still keeps more than 50 % of the initial tensile strength, provided of course the glass reinforced Flexible PolyPropylene is adequately heat stabilized.

### EXAMPLES and BEST MODE of the INVENTION

The invention will be further clarified by the following examples which are not meant to restrict the scope to the specific provided examples. Other combinations of the preferred features than those shown are also possible and useful.

### 1) Examples of separation layers and backsheets permeable to acetic acid:

One produces by coextrusion or coextrusion / lamination the following multi-layer films:
- Film A):
   "50 µm FPP (*) based layer / 200 µm FPP (**) based layer with 12 % glass fibers" (11) / 25 µm RCPgMAH (***)based tie-layer (12d) / 75 µm of PA 6, nucleated grade (12c) / 25 µm of PEgMAH based tie-layer (12b)
- Film B):
   "50 µm FPP (*) based layer / 25 µm RCPgMAH (***) based tie-layer/ 40 µm of PA 6, nucleated grade / 25 µm RCPgMAH (***) based tie-layer / 100 µm FPP (*) based layer, colaminated on 100 µm FPP (*) based layer" (11) / 25 µm of RCPgMAH (***) based tie-layer (12d) / 40 µm of PA 6, nucleated grade (12c) / 25 µm of PEgMAH based tie-layer (12b)
- Film C):
   25 µm of PEgMAH based tie-layer (112b) / 75 µm of PA 6 (7), nucleated grade / 25 µm of PEgMAH based tie-layer (112b).
      (*) a blend of Hifax CA 10 A and Hifax CA 60, with usual additives (UV and heat stabilizers, like phenolic and phophite anti-oxidants, possibly a thiosynergist, flame retardants like Magnesium Hydroxide, pigments like TiO2, ...)
      (**) a blend 40 parts of Hifax CA 138 and 60 parts of Hifax CA 60, with usual additives (UV and heat stabilizers, flame retardants especially Magnesium Hydroxide with surface treatment, pigments like TiO2, ...) and treated (aminosilane) glass fibers (12 % of the weight of the blend Hifax CA 138 and Hifax CA 60) with addition of PPgMAH compatibilizer adhesive resin (adhesive between the surface treated glass fibers and the FPP matrix).
      (***) a random copolymer of polypropylene preferably in blend with EPR rubber or another compatible rubber, functionalized (grafted) by reactive extrusion with maleic anhydride

The permeability to acetic acid is estimated at 60°C as follows: A stainless steal cup is filled with acetic acid and closed with the film under evaluation. The closed cup is weighed and put into a chamber evacuated by a vacuum pump at 60°C during 14 days. The loss of weight of the closed cup is then measured and expressed in g/m².day.

The results are presented in comparison with a Tedlar/PET/Tedlar (TPT) film of 170 µm.

| | |
|---|---|
| Film A: | > 100 g/m².day |
| Film B: | > 100 g/m².day |
| Film C: | > 300 g/m².day |
| TPT: | < 10 g/m².day (counter example) |

Films A and B can be used as backsheet allowing high egress of acetic acid released from EVA encapsulant.

Film C can be used as internal insulating layer (7) avoiding trapping of acetic acid.

The TPT film can be useful as internal insulating layer (7) when micro-perforated. The amount of micro-perforation is adjusted to achieve a permeability to acetic acid of more than 20 g/m²•day.

Further Film A and B can be equipped with an integrated adhesive (13b/12a) to reduce production of acetic acid inside the PV module.

Further Film C can be embedded in polyethylene (VLDPE ...) based adhesive to reduce production of acetic acid inside the PV module.

### 2) Examples of suitable FPP blends and films thereof to produce FPP based layers:

Following films are produced and evaluated for their Heat of fusion, cold foldability and acetic acid permeability (60°C):

| Films | Heat of fusion - (J/g) | Cold Foldability - EN 495/5 (°C) | Acetic Acid Permeability - (g/m².day) |
|---|---|---|---|
| 0,5 mm film on base of Hifax CA 10 A or CA 60 or CA 212 | +/- 30 | < - 40 | 200 |
| 0,5 mm film on base of Hifax CA 12 A | +/- 46 | < - 40 | 85 |
| 0,5 mm film on base of Hifax CA 138 | +/- 52 | < - 40 | 82 |
| 0,5 mm film on base of Hifax CA 02 | +/- 19,5 | < - 40 | 275 |
| 0,5 mm film on base of Hifax CA 7441 | +/- 31 | < - 40 | 220 |
| Counter-example 0,5 mm film on base of Homo PP Moplen HP 456J | +/- 104 | >-20 | 10 |

The heat of fusion is measured at the second heating at 10 K/minute by integration of the heat of fusion from 80°C to 180°C, with as heat flow baseline, the line between heat flow value at 0°C and heat flow value at 180°C.

By comparing the heat of fusion of the FPP blend with a common PP resin, it is easy to select a suitable FPP blend. The heat of fusion of a suitable FPP blend will be less than 70 % of the heat of fusion of a PP resin (reference PP resin is PP Moplen HP 456J), preferably less than 60 %, more preferably less than 50%.

The cold bending test (EN 495/5) is a good way to recognize a suitable FPP based layer as low temperature cold foldability (-20°C, especially - 40°C) is difficult to achieve when the blend of PP and rubber is not (semi-)interpenetrated (if the PP and rubber phases are not co-continuous i.e. are separated).

The reference PP resin film, of Homo PP Moplen HP 456J, has a poor cold foldability and low permeability to acetic acid. Its high rigidity combined to a high CLTE may lead to unacceptable stresses to the PV cells. Its brittleness at low temperature constitutes a major safety hazard (cracks in backsheet and loss of electrical insulation).

It has to be observed that the higher the heat of fusion, the lower the permeability to acetic acid. It is therefore preferred to select a FPP blend with a low heat of fusion, meaning a high rubber content.

Of course, when the FPP blend is completely melted at lamination temperature (typically 145 à 155 °C), the mechanical integrity of the backsheet may be compromised. If required, the man skilled in the art will have a look to the DSC measurements (curves) of the FPP based layer(s) and select FPP blends which are not completely melted at lamination temperature (i.e. which have a residual heat of fusion above lamination temperature).

Addition of fillers (talcum, glass fibers) will further help to keep mechanical integrity during lamination, reduce CLTE and increase stiffness.

### 3) Examples of PA-FPP backsheet with good heat distorsion (mechanical integrity at lamination temperature) and flow resistance (good adhesion of EVA with PV module front layer at edges and corners) and/or elevated RTI or RTE (heat aging), resistance to humidity and discoloration even when combined with EVA encapsulants.

Addition of glass fibers in the FPP blend and combining the FPP blend based layers with a polyamide layer will much improve the retention of mechanical properties at lamination temperature and dimensional stability. Glass fibers help to control initial mechanical properties of all layers, in order to allow the FPP layers to dominate in the mechanical properties. Because FPP layers can be stabilized to achieve a RTI of typically 115°C, the backsheet achieves such result when the FPP layers dominate in the tensile strength of the backsheet.

The FPP layers dominate in the mechanical properties because the FPP layers are reinforced (stiffened) and/or because the PA layer(s) have their mechanical properties reduced by inclusion of fillers especially glass fibers.

### Example 3.1):

One produces by coextrusion the following backsheet:
a) 50 µm of a PE-g-MAH based tie-layer (100 parts of LLDPE grafted with maleic anhydride; 10 parts of TiO2 Kronos 2220; 0,1 parts of low gas fading phenolic anti-oxidant ADK Stab AO-80; 0,3 parts of phosphite secondary anti-oxidant Weston 705; HALS: 0,3 parts of Cyasorb UV 3529).
b) 75 µm of a PA 6 based layer (100 parts of PA 6; 10 parts of TiO2 Kronos 2220; 0,3 parts of ADK Stab AO-80; 0,3 parts of Irgafos 168; HALS; PE-g-MAH carrier)
c) 25 µm of a PP/EPR-g-MAH based tie-layer (100 parts of "PP-EPR" blend, grafted with maleic anhydride; 10 parts of TiO2 Kronos 2220; 0,3 parts of lrganox 1010; 0,6 parts of lrganox PS 802; 0,15 parts of Irgafos 168).
d) 200 µm of a glass fiber reinforced FPP compound (40 parts of Hifax CA 138, 60 parts of Hifax CA 60; 20 parts of treated glass fibers; 2 parts of PP-g-MAH compatibilizer; 10 parts of TiO2 Kronos 2220; 0,3 parts of Irganox 1010; 0,6 parts of lrganox PS 802; 0,15 parts of Irgafos 168. - see (*)).
e) 50 µm of a FPP blend (Hifax CA 212, 100 parts;10 parts of TiO2 Kronos 2220; 0,3 parts of lrganox 1010; 0,6 parts of Irganox PS 802; 0,15 parts of Irgafos 168).

(*) The length of the glass fibers (e.g. Lanxess CS 7952) are preferably reduced to maximum 500 µm during the compounding step (production of the glass reinforced compound on co-rotating twin screw extruders with kneading elements for adjusting glass fibers length) and more preferably to 300 µm and if required (capillarity) to less than 300 µm. Shorter glass fibers may be used (e.g. Lanxess MF 7982) in mixture.

A sample of the backsheet is aged at 150°C during 5 weeks. The tensile strength is measured according to Iso 527-3 and found superior to 50 % of the initial value. It is further observed that no delamination occurs after 5 weeks heat aging. By extrapolation, a RTI or RTE of +/- 115°C should be achieved.

It is further observed that addition of glass fibers in the FPP blend and combining the FPP blend based layers with a polyamide layer much improves the retention of mechanical properties at lamination temperature and dimensional stability / flow resistance (EVA adhesion at edges and corners of glass front layer) during module lamination (glass / EVA / cells / EVA / backsheet vacuum lamination - 150°C 15 minutes).

The produced backsheet (400 µm) provides a system voltage of more than 1200 VDC.

By increasing the thickness of layer d) from 200 µm to 400 µm (total thickness = 600 µm) the backsheet provides a system voltage of more than 1500 VDC. The rubber content of layer d) can be increased to adjust softness and improve acetic acid permeability.

### Counter-Example 3.2):

For comparison, layer b) is aged 2 weeks at 150°C and found to have a tensile strength less than 50 % of the initial value. The same is observed for the complete backsheet (a/b/c/d/e layers) when glass fibers are eliminated from composition of layer d).

### Example 3.3):

A vacuum laminated (usual conditions for PV module i.e. 150°C - 15 minutes) sample of "Glass (3,2 mm) / EVA 0,46 mm (Vistasolar 486.10) * 2 / coextruded Backsheet of the example 3.1)" is aged 1000 hours at 85°C/85 % relative humidity. The discoloration (delta Yi - ASTM E313-73 (D1925)) is found acceptable (< 10).

### Example 3.4):

Layer a) of example 3.1) is replaced by a 50 µm of a PE-g-MAH based tie-layer with formulation (without phenolic stabilizer): 100 parts of LLDPE grafted with maleic anhydride; 10 parts of Ti02 Kronos 2220; 0,3 parts of Weston 705; HALS: 0,3 parts of Cyasorb UV 3529.

A vacuum laminated (usual conditions for PV module i.e. 150°C - 15 minutes) sample of "Glass (3,2 mm) / EVA 0,46 mm (Vistasolar-486.10) * 2 / coextruded Backsheet of the example 3.4)" is aged 1000 hours at 85°C/85 % relative humidity. The discoloration (delta Yi - ASTM E313-73 (D1925)) is found acceptable (delta Yi < 10).

### Example 3.5):

Same as example 3.4), but Nylostab S-EED (Clariant) is used in layer b) instead of ADK Stab AO-80.

A vacuum laminated (usual conditions for PV module i.e. 150°C - 15 minutes) sample of "Glass (3,2 mm) / EVA 0,46 mm (Vistasolar 486.10) * 2 / coextruded Backsheet of the example 3.5)" is aged 1000 hours at 85°C/85 % relative humidity. The discoloration (delta Yi - ASTM E313-73 (D1925)) is found acceptable (delta Yi < 10).

### Counter-Example 3.6):

For comparison, the phenolic anti-oxidant (ADK Stab AO-80) in layers a) and b) of example 3.1) is replaced by 0,3 phr of a standard anti-oxidant (Irganox 1010) sensitive to gas fading.

A vacuum laminated (usual conditions for PV module i.e. 150°C - 15 minutes) sample of "Glass (3,2 mm) / EVA 0,46 mm (Vistasolar 486.10) * 2 / coextruded Backsheet of the example 3.6)" is aged 1000 hours at 85°C/85 % relative humidity. The discoloration (delta Yi - ASTM E313-73 (D1925)) is found unacceptable (delta Yi > 10 and severe pinking is observed).

### Example 3.7):

One produces by coextrusion the following backsheet:
a) 50 µm of a PE-g-MAH based tie-layer (100 parts of LLDPE grafted with maleic anhydride; 10 parts of TiO2 Kronos 2220; 0,1 parts of ADK Stab AO-80; 0,3 parts of ADK STAB PEP-36; HALS: 0,3 parts of Cyasorb UV 3529).
b) 75 µm of a PA 6 based layer (100 parts of PA 6; 10 parts of TiO2 Kronos 2220; 0,3 parts of ADK Stab AO-80; 0,3 parts of ADK STAB PEP-36; HALS; PE-g-MAH carrier)
c) 25 µm of a PP/EPR-g-MAH based tie-layer (100 parts of "PP-EPR" blend, grafted with maleic anhydride; 10 parts of TiO2 Kronos 2220; 0,3 parts of lrganox 1010; 0,6 parts of Irganox PS 802; 0,15 parts of lrgafos 168).
d) 125 µm of a glass fiber reinforced FPP compound (50 parts of Hifax CA 138; 50 parts of Hifax CA 60; 10 parts of treated glass fibers; 1 parts of PP-g-MAH compatibilizer; 10 parts of TiO2 Kronos 2220; 0,3 parts of Irganox 1010; 0,6 parts of lrganox PS 802; 0,15 parts of lrgafos 168-see (*))).
e) 25 µm of a PP/EPR-g-MAH based tie-layer (100 parts of "PP-EPR" blend, grafted with maleic anhydride; 10 parts of TiO2 Kronos 2220; 0,3 parts of Irganox 1010; 0,6 parts of Irganox PS 802; 0,15 parts of lrgafos 168).
f) 50 µm of a Polyamide 12 layer (100 parts of PA 12; 10 parts of TiO2 Kronos 2220; 0,3 parts of ADK Stab AO-80; 0,3 parts of ADK STAB PEP-36; HALS)
Such backsheet excels in heat resistance (2 layers of polyamide)

### Example 3.8):

As example 3.1) but the glass fibers are included (10 parts) in the polyamide 6 based b) layer instead than in the FPP based d) layer.

A sample of the backsheet is aged at 150°C during 5 weeks. The tensile strength is measured according to Iso 527-3 and found superior to 50 % of the initial value. It is further observed that no delamination occurs after 5 weeks heat aging. By extrapolation, a RTI of +/- 115°C should be achieved.

The system voltage of the backsheet is > 1000 VDC (IEC 60664-1:2007).

### Example 3.9):

As example 3.1) but glass fibers are included (10 parts) in the polyamide 6 based b) layer and the amount of glass fiber in the FPP based d) layer is reduced to 10 parts instead of 20 parts.

A sample of the backsheet is aged at 150°C during 5 weeks. The tensile strength is measured according to Iso 527-3 and found superior to 50 % of the initial value. It is further observed that no delamination occurs after 5 weeks heat aging. By extrapolation, a RTI of +/- 115°C should be achieved.

It is further observed that addition of glass fibers in the FPP blend and combining the FPP blend based layers with a polyamide layer much improves the retention of mechanical properties at lamination temperature and dimensional stability during module lamination (glass / EVA / cells / EVA / backsheet vacuum lamination - 150°C 15 minutes).

### Example 3.10):

One produces by coextrusion the following backsheet:
a) 50 µm of a PE-g-MAH based tie-layer (100 parts of LLDPE grafted with maleic anhydride; 10 parts of TiO2 Kronos 2220; 0,1 parts of ADK Stab AO-80; 0,3 parts of ADK STAB PEP-36; HALS: 0,3 parts of Cyasorb UV 3529).
b) 75 µm of a PA 6 based layer (100 parts of PA 6; 10 parts of TiO2 Kronos 2220; 0,3 parts of ADK Stab AO-80; 0,3 parts of ADK STAB PEP-36; HALS; PE-g-MAH carrier)
c) 25 µm of a PP/EPR-g-MAH based tie-layer (100 parts of "PP-EPR" blend, grafted with maleic anhydride; 10 parts of TiO2 Kronos 2220; 0,3 parts of Irganox 1010; 0,6 parts of Irganox PS 802; 0,15 parts of Irgafos 168).
d) 200 µm of a glass fiber reinforced FPP compound (50 parts of Hifax CA 138; 50 parts of Hifax CA 60; 10 parts of treated glass fibers; 1 part of PP-g-MAH compatibilizer; 10 parts of TiO2 Kronos 2220; 0,3 parts of lrganox 1010; 0,6 parts of Irganox PS 802; 0,15 parts of lrgafos 168-see (*))).
e) 50 µm of a FPP blend (Hifax CA 212, 100 parts;10 parts of TiO2 Kronos 2220; 0,3 parts of Irganox 1010; 0,6 parts of Irganox PS 802; 0,15 parts of lrgafos 168).
With the limited amount of glass fibers in the FPP layer, the coextrusion is easier.
One produces a PV module (glass / EVA vistasolar 486.10 0,46 mm / cells / EVA vistasolar 486.10 0,46 mm / backsheet) with backsheet of example 3.10) by vacuum lamination - 150°C 15 minutes; 1 bar laminating pressure).
The front EVA has good adhesion with the front layer (glass) even at PV module corners and edges.

### Counter-example 3.11):

Same as example 3.10) but no glass fibers are added in layer d).
The front EVA has poor adhesion with the front layer (glass) at PV module corners and edges.

### Example 3.12):

One produces by coextrusion the following backsheet:
a) 50 µm of a PE-g-MAH based tie-layer (100 parts of LLDPE grafted with maleic anhydride; 10 parts of TiO2 Kronos 2220; 0,1 parts of ADK Stab AO-80; 0,3 parts of ADK STAB PEP-36; HALS: 0,3 parts of Cyasorb UV 3529).
b) 75 µm of a PA 6 based layer (100 parts of PA 6; 10 parts of TiO2 Kronos 2220; 0,3 parts of ADK Stab AO-80; 0,3 parts of ADK STAB PEP-36; HALS; PE-g-MAH carrier)
c) 25 µm of a PP/EPR-g-MAH based tie-layer (100 parts of "PP-EPR" blend, grafted with maleic anhydride; 10 parts of TiO2 Kronos 2220; 0,3 parts of Irganox 1010; 0,6 parts of Irganox PS 802; 0,15 parts of lrgafos 168).
d) 200 µm of a FPP blend (Hifax CA 212, 100 parts; 10 parts of TiO2 Kronos 2220; 0,3 parts of lrganox 1010; 0,6 parts of Irganox PS 802; 0,15 parts of lrgafos 168).
The system voltage of the Backsheet (IEC 60664-1:2007) is found to be more than 1000 VDC at a RTI rating of 90°C.
In adhesion layers c)-d) provide a system voltage of more than 600 VDC at a RTI rating of 110°C or more and in adhesion layers c)-d) have a relative thermal endurance of 110°C or more (IEC 60216-1 (2001-07)).

### 4) Example of a front encapsulant with EVA and VLDPE layers, with excellent transparency, compatibility of additives and allowing for reduction of Potential Induced Degradation of PV modules.

One produces by coextrusion a encapsulant comprising a core VLDPE based layer and two external layer on base of EVA:
- 100 µm EVA based layer
- 250 µm VLDPE based layer
- 100 µm EVA based layer

To achieve high transparency, the EVA has a VAc content of more than 25 % and e.g. 33 %.

To achieve high transparency, the VLDPE has a DSC melting temperature of less than 100°C and is produced on base of single catalyst technology (Engage or Exact types of VLDPE) with as example Exact ® 82xx, where xx refers to the fluidity and 82 to the density (0,882 g/cm³).

To be processed (coextrusion), the viscosity of the layers is adapted. In particular when peroxides are added for heat crosslinking, polymers with a MI of more than 10, preferably of more than 20, even more preferably of more than 25 (g/10m; 190°C; 2,16 kg) are preferred.

Each layers comprises usual additives, for example 0,1 % of Tinuvin ® 770 (common HALS), 0,2 % of Irgafos 168 (phosphite anti-oxidant) and 0,3 % of Chimassorb ® 81 (UV absorber).

To achieve adhesion to glass and heat crosslinking during module lamination, silane and peroxide and possibly multi-functional crosslinkers are added to layers, for example 0,5 % MEMO Silane (Gamma-Methacryloxypropyl trimethoxysilane) and 1,5 % Luperox ® TBEC and 0,5 % of TAIC (Tria Allyl IsoCyanurate)

To achieve adhesion to glass and UV crosslinking after module lamination, silane and UV photoinitiators and possibly multi-functional crosslinkers are added to layers, for example 0,5 % MEMO Silane (Gamma-Methacryloxypropyl trimethoxysilane) and 1 % Benzophenone and 0,5 % of TAIC (Tria Allyl IsoCyanurate)

After peroxide or UV crosslinking, it is observed than the adhesion between coextruded layers (EVA/VLDPE) is improved and become satisfactory.

It is also possible to achieve or improve crosslinking of the VLDPE based layer by humidity (on site) when the VLDPE is grafted with silane (by reactive extrusion), e.g. with 2 % of VTMO. Condensation catalyst may be added to the VLDPE layer, possibly by migration from another (supplementary) layer (not equipped with grafted silane to avoid premature crosslinking).

After storage, it is observed that the additives are kept inside the encapsulant (compatibility with EVA). This is not the case when only VLDPE based layers are used.

PV modules (Glass / front encapsulant / PID sensitive cells / EVA / TPT backsheet) are produced with as front encapsulant EVA or the coextruded front encapsulant (EVA-VLDPE-EVA) and submitted to heat and damps (85°C / 85 % Relative Humidity) under cell bias (Glass at 300 VDC and cells grounded). It is observed that the shunt resistance of the cells decreases quickly when a EVA front encapsulant is used, while it is more stable when the coextruded front encapsulant (EVA-VLDPE-EVA) is used.

As will be apparent the foregoing description does not cover all possible combinations. Other combinations may be derived by the man skilled in the art from the present description and are useful.

### List of reference numbers

- 1: front layer like glass plate
- 2: upper adhesive layer
- 4: photovoltaic cells, active material
- 5: rear encapsulant like EVA or tie-layer (13b) / soft co-PE (12a)
- 6: interconnected conductive ribbon,
- 66: interconnected conductive ribbon highly corroded
- 7: electrically insulating layer (embedded in 2 layers of EVA or in 2 sets of 113b/112a/112b layers)
- 10: Backsheet preferably including connecting layers (12) and possibly rear encapsulant (13b)/(12a) or Backsheet preferably including connecting layers (12) and separated rear e.g. EVA encapsulant
- 11: FPP layers / backsheet
- 12a: Encapsulating layer(s)
- 12b ...: Connecting layers
- 13b: PE based tie-layer in direct contact with the PV cells (4)
- 20: Membrane of the vacuum laminator
- 30: Lateral flow under pressure and heat (and later in the other direction during cooling)
- 40: Adhesion defect between glass (or front sheet) (1) and front encapsulant (2) (EVA or other front encapsulant like VLDPE based front encapsulant especially when having low viscosity and melting temperature) at the edges and especially corners of the PV modules

## Claims

1. A PV module comprising:
- a front layer (1)
- at least one encapsulant film releasing detrimental by-products, in particular acetic acid
- PV cells (4)
- interconnecting conductive ribbon (6)
- an electrically insulating film (7) with a permeability to acetic acid, determined as weight loss of acetic acid through the film at 60 °C under vacuum, of more than 20 g/m²·day
- a backsheet (11-10).

2. The PV module of claim 1, wherein the backsheet (11-10) is based mainly on TPO and/or Polyamide based layers.

3. The PV module of claim 1, wherein the backsheet (11-10) comprises a microperforated PET or PBT layer.

4. A backsheet comprising at least following layers:
i. (a) one or more heat resistant layer, e.g. polyamide based layer(s) or EVOH based layer(s) or polyamide/EVOH blend based layer(s) or possibly micro-perforated layer(s) e.g. on base of polyester resins, with a total thickness between 10 µm and 400 µm, acting mainly as heat resistant anti-perforation and/or crosslinking agents barrier layers
ii. (b) one or more adhesive layer(s) especially tie-layer(s) on base of heat stabilized functionalized PolyPropylene or Flexible PolyPropylene, as adhesive layer(s) between the heat resistant layer(s), e.g. polyamide based layer(s) and the FPP based layer(s)
iii. (c) one or more layer(s) based on heat and UV stabilized Flexible
PolyPropylene"
Where layers (b) and especially (c) act as dielectric layer or layer(s) having a RTI of at least 105°C by addition of anti-oxidants and having a total thickness of at least 100 µm, providing a system voltage (IEC 60664-1:2007) of 600 VDc or more

5. The backsheet of claim 4 where fillers are added in one or more backsheet layers, especially in FPP based or Polyamide based layers, in such a way that the FPP layers dominate in the tensile properties of the backsheet, where the fillers are preferably fibers, preferably glass fibers, in a preferred amount ranging from 3 to 30 %, more preferably 5 to 25 %.

6. The backsheet of claim 4 or 5 comprising at least one heat stabilized polyamide 11 or 12 based layer

7. The backsheet of claim 4, 5 or 6 further coextruded at the cell side with a (co-)PE based tie-layer.

8. The backsheet of claim 4, 5, 6 or 7, where the polyamide layer facing the PV cells (4) is heat stabilized by a non phenolic heat stabilizers, especially of the type of Nylostab SEED ® or by a specific phenolic anti-oxidant being of the type of Adeka AO 80 ® or of the type of Irganox 245 ®.

9. A backsheet comprising at least following layers:
i. (a) A polyamide based layer
ii. (b) A tie-layer on base of heat stabilized PolyPropylene or Flexible PolyPropylene
iii. (c) A possibly multi-layer layer on base mainly of heat stabilized Flexible PolyPropylene layer or layer(s)
Where the polyamide based layer is stabilized by a master batch on base of a polyolefin carrier, possibly functionalized,

10. A encapsulant film comprising at least one non polar co-PE based layer and at least one polar co-PE based layer, preferably cross-linked, to achieve better in field interlayer adhesion.

11. A backsheet comprising one or more heat stabilized FPP based layer(s) having a Relative thermal endurance of 105°C or even 110°C or even 115° or even more, according to IEC 60216-1 (2001-07), i.e. a retention of tensile strength of more than 50 % of its initial value after 20.000 hours of heat aging at 105°C or even 110°C or even 115° or even more, or having a RTI of 105°C or even 110°C or even 115°C or even more (UL 746 B), by the addition of anti-oxidants in the FPP based layer(s), where the FPP based layer(s), in adhesion with possible heat stabilized tie-layers and/or PP based layers, provide a system voltage test of more than 1000 VDC (IEC 60664-1:2007) without excessive shrinkage stress during module production, i.e. acceptable edge adhesion

12. The backsheet of claim 11. coextruded with a Polyamide 6 layer achieving a system voltage test of 1500 VDC or more and having a Relative thermal endurance of 90°C or even 95°C or even 100° C according to IEC 60216-1 (2001-07), or having a RTI of 90°C or even 95°C or even 100°C (UL 746 B).

13. The backsheet of claim 4 where the polyamide is provided in blend with polyolefin to reduce the dielectric constant of the polyamide.
